# EUROPEAN PATENT SPECIFICATION

(11) **EP 0 297 848 B1**
(45) Date of publication and mention of the grant of the patent: **11.01.1995**
(21) Application number: 88305903.2
(22) Date of filing: 29.06.1988
(51) Int. Cl.: H03D 1/10

(54) **Temperature stabilized RF detector**
Temperaturstabilisierter RF-Detektor
Détecteur RF stabilisé en température

(30) Priority: 02.07.1987 JP 166343/87
(43) Date of publication of application: 04.01.1989
(73) Proprietor: NEC CORPORATION, Tokyo (JP)
(72) Inventor: Tamura, Yoshiharu, Tokyo (JP)
(74) Representative: Orchard, Oliver John

(56) References cited:
- US-A- 4 523 155
- PATENT ABSTRACTS OF JAPAN, vol. 5070, (E-056), 12th May 1981;& JP-A-56 019 211 (MITSUBISHI ELECTRIC CORP.) 23-02-1981
- PATENT ABSTRACTS OF JAPAN, vol. 5070 (E-056), 12th May 1981;& JP-A-56 019 209 (MITSUBISHI ELECTRIC CORP.) 23-02-1981
- PATENT ABSTRACTS OF JAPAN, vol. 7200 (E-196), 3rd September 1983;
- & JP-A-58 099 009 (TOKYO SHIBAURA DENKI K.K.) 13-06-1983

## Description

The present invention relates to an RF (radio frequency) detector and, more particularly, to a temperature stabilized RF detector using a diode.

An RF detector utilizing the half-wave rectification function of a diode has been widely used.

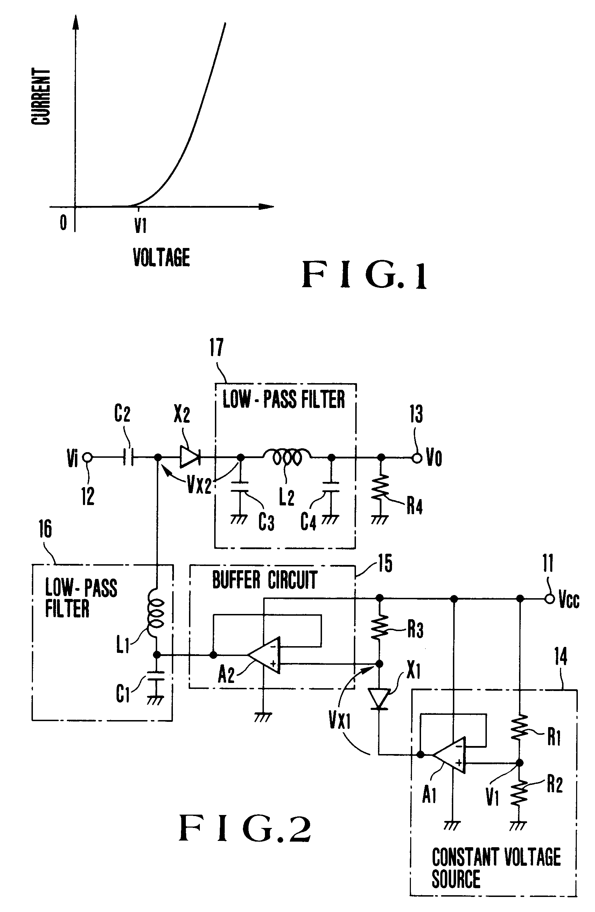

As shown in the graph of voltage-current characteristics in Fig. 1, a diode does not almost allow a current to pass therethrough until a forward voltage reaches a voltage V₁ (e.g., 0.5 V). For this reason, in a conventional RF detector, a bias voltage V_{B} near the voltage V₁ is applied to the diode to improve a detection sensitivity to a small signal.

Suppose that a detection voltage obtained by rectifying a high frequency signal by the diode is represented by V_{DET}, and a voltage drop across the terminals of the diode due to a current is represented by V_{X}, an output voltage Vₒ is expressed as follows:${\text{V}}_{\text{o}} {\text{= V}}_{\text{DET}} {\text{+ V}}_{\text{B}} {\text{- V}}_{\text{X}}$

Since the voltage drop V_{X} is given by a function of the current and temperature, if the bias voltage V_{B} is constant, the output voltage Vₒ also changes depending on the temperature. To compensate these changes in output voltage Vₒ due to the temperature, another diode is coupled to a bias circuit which supplies the bias voltage V_{B}. The reference is made to U.S. Patent No. 4,523,155 issued to Walczak et al, June 11, 1985. The RF detector circuit described in this patent does not, however, provide sufficient temperature compensation when an input RF signal is small.

In the specification of Japanese Patent application No. 56019211, as shown in an abstract which was published in the Patent Abstracts of Japan, Vol. 5070, (E-056) on May 12 1981, there is proposed a circuit for keeping the gain of a detector diode constant by varying a bias voltage applied to the detector diode in accordance with variations in temperature, using a series connected similarly poled temperature detecting diode and an operational amplifier to ensure a constant current through the detector diode.

In the specification of Japanese Patent Application No. 58099009, as shown in an abstract which was published in the Patent Abstracts of Japan, Vol. 7200 (E-196) on September 3 1983, there is proposed a detector diode circuit for keeping a detected output voltage constant, in which there is an operational amplifier connected across a second diode to produce a voltage which is temperature dependent and which corresponds to a constant current across the second diode, the voltage produced being applied to the detector diode to keep the output constant.

An aim of the present invention is to provide a temperature stabilized RF detector having desirable temperature characteristics for a small signal.

The following description and drawings disclose, by means of an example, the invention which is characterised in the appended claims, whose terms determine the extent of the protection conferred hereby.

In the drawings:-
Fig. 1 is a graph showing the voltage-current characteristics of a diode; and
Fig. 2 is a circuit diagram showing an embodiment of the present invention.

In Fig. 2, reference numeral 11 denotes a power supply terminal of a power supply voltage V_{cc}; 12, an RF signal input terminal for receiving an RF signal of a voltage Vᵢ; and 13, a detection voltage output terminal for outputting an RF detection signal of a detection voltage Vₒ.

The power supply terminal 11 is grounded through a series circuit of resistors R₁ and R₂. The node between the resistors R₁ and R₂ is connected to the non-inverting input terminal of an operational amplifier A₁. That is, a voltage appearing at the non-inverting input terminal of the operational amplifier A₁ is maintained at V₁ (= V_{cc}·R₂/(R₁ + R₂).

The inverting input terminal of the operational amplifier A₁ is directly connected to its output terminal. Since the output voltage is fed back to the inverting input terminal, even if the output current changes, the output voltage is maintained at a voltage V₁ input at the non-inverting input terminal. More specifically, the operational amplifier A₁ and resistors R₁ and R₂ constitute a constant voltage source 14 for outputting the voltage V₁ at a low output impedance.

The cathode of a diode X₁ is connected to the output terminal of the operational amplifier A₁. The anode of the diode X₁ is connected to the power supply terminal 11 through a resistor R₃, and to the non-inverting input terminal of an operational amplifier A₂.

The inverting input terminal of the operational amplifier A₂ is directly connected to its output terminal. Since the output voltage of the operational amplifier A₂ is fed back to its inverting input terminal, even if an output current changes, the output voltage can be maintained at a voltage input at its non-inverting input terminal. More specifically, the operational amplifier A₂ constitutes a buffer circuit 15 for outputting a voltage at the anode of the diode X₁ at a low output impedance.

The operational amplifiers A₁ and A₂ respectively have terminals connected to the power supply terminal 11, and grounded terminals.

The RF input terminal 12 is connected to one terminal of a capacitor C₂. The other terminal of the capacitor C₂ is grounded through a series circuit consisting of an inductor L₁ and a capacitor C₁, and is connected to the anode of a diode X₂. The series circuit of the inductor L₁ and the capacitor C₁ constitutes a low pass filter 16 for preventing the RF signal Vᵢ input from the input terminal 12 from flowing toward the operational amplifier A₂. The capacitor C₂ is a coupling capacitor for coupling the RF signal Vᵢ to the diode X₂ and separating the diode X₂ from the input terminal 12 in DC voltages.

The node between the inductor L₁ and the capacitor C₁ is connected to the output terminal of the operational amplifier A₂.

The cathode of the diode X₂ is connected to one terminal of each of a capacitor C₃ and an inductor L₂. The other terminal of the capacitor C₃ is grounded, and the other terminal of the inductor L₂ is connected to the output terminal 13.

One terminal of each of a capacitor C₄ and a resistor R₄ is connected to the output terminal 13. The other terminal of each of the capacitor C₄ and the resistor R₄ is grounded. The capacitors C₃ and C₄ and the inductor L₂ constitute a low pass filter 17 which prevents the high frequency signal Vᵢ from flowing toward the output terminal 13, and directly couples the diode X₂ to the output terminal 13. The resistor R₄ serves as a load resistor.

The operation of the detector shown in Fig. 2 will be described below.

A differential voltage between the power supply voltage V_{cc} and the constant voltage V₁ is applied to the series circuit across the diode X₁ and the resistor R₃. The resistance of the resistor R₃ is adjusted so that a small forward current (to be described later) is flowed through the diode X₁. If a voltage drop of the diode X₁ is given by V_{X1}, its anode voltage is expressed by V₁ + V_{X1}. This anode voltage is applied to the non-inverting input terminal of the operational amplifier A₂.

The output voltage from the operational amplifier A₂, i.e., V₁ + V_{X1}, is applied to the anode of the diode X₂ through the inductor L₁.

If a voltage drop across the diode X₂ is given by V_{X2}, and a detection voltage obtained by rectifying the RF signal Vᵢ by the diode X₂ is given by V_{DET2}, the output voltage Vₒ at the output terminal 13 is expressed as:${\text{V}}_{\text{o}} {\text{=V}}_{\text{DET2}} {\text{+ V₁ + V}}_{\text{X1}} {\text{- V}}_{\text{X2}}$

That is, the voltage drop V_{X1} across the diode X₁ has an opposite polarity to the voltage drop V_{X2} across the diode X₂.

When the RF signal Vᵢ is a small signal, the voltage V₁ and the resistance of the resistor R₃ are set so that a current of the diode X₂ becomes equal to that of the diode X₁, and the detection sensitivity is improved. As a result of this setting, if the RF signal Vᵢ is a small signal, the voltage drops V_{X1} and V_{X2} become equal to each other as well as their temperature characteristics, and the output voltage Vₒ is given by:${\text{V}}_{\text{o}} {\text{= V}}_{\text{DET2}} \text{+ V₁}$
Therefore, a change in output voltage Vₒ due to a temperature can be removed.

Since the output impedances of the operational amplifiers A₁ and A₂ for respectively outputting the voltage V₁ and the voltage (V₁ + V_{X1}) are small, even if currents of the diodes X₁ and X₂ change due to a change in temperature, a constant component V₁ of the bias voltage (V₁ + V_{X1}) applied to the diode X₂ is not changed.

If the RF signal voltage Vᵢ is increased and the diodes X₁ and X₂ have different current values, change components of the voltage drops V_{X1} and V_{X2} are not always equal to each other, and the temperature characteristics of terms V_{X1} and V_{X2} of the output voltage Vₒ given by equation (2) do not always cancel with each other. In this case, the detection voltage V_{DET2} becomes sufficiently large, and a change in output voltage Vₒ due to a change in temperature based on a change in (V_{X1} - V_{X2}) due to a change in temperature can be ignored.

As described above, an RF detector having desirable temperature stabilized characteristics even when the input signal voltage Vᵢ is small can be obtained.

The embodiment of the present invention has been described with reference to a case wherein the power supply voltage V_{cc} is positive. However, when the power supply voltage is negative, the connection polarities of the diodes X₁ and X₂ can be inverted to be opposite to those illustrated in Fig. 2.

## Claims

1. A temperature stablized RF detector for detecting an RF signal applied to an RF input terminal (12), and obtaining a detected voltage from an output terminal (13), including a waveform detector diode (X2) having one electrode connected to the input terminal (12) and another electrode connected to the output terminal (13), a temperature detecting diode (X1), a power supply terminal (11), and an operational amplifier (A2) connected between one electrode of the diode (X1), and the one electrode of the waveform detector diode (X2), the power supply terminal (11) being connected to the one electrode of the temperature detecting diode (X1), characterised in that the power supply terminal (11) is connected to the one electrode of the temperature detecting diode (X1) via a resistor (R3) and in that the other electrode of the temperature detecting diode (X1) is connected to a constant voltage source (14) supplied from the power supply terminal (11), the source (14) providing a predetermined voltage at a low output impedance, the operational amplifier (A2) forming a part of a buffer circuit (15) which provides an output voltage which is substantially equal in value to the voltage at the one electrode of the temperature detecting diode (X1), the output voltage of the buffer circuit (15) being provided at a lower output impedance, and the one electrode of the waveform detector diode (X2) which is connected to the output of the buffer circuit (15) being of the same polarity as that of the one electrode of the temperature detecting diode (X1) which is connected to the input of the buffer circuit (15).

2. A temperature stablized RF detector as claimed in claim 1, characterised in that there is provided a low pass filter, between the input terminal (12) and the buffer circuit (15), for preventing the RF signal from flowing from the input terminal (12) to the buffer circuit (15).

3. A temperature stablized RF detector as claimed in claim 1 or claim 2, characterised in that the resistance of the resistor (R3) is such that, when an RF signal voltage input from the input terminal (12) is small, the value of current flowing through the waveform detector and the temperature detecting diodes (X2, X1) are equal to each other, and in that when the values of current flowing through the waveform detector and temperature detecting diodes are equal to each other, the temperature characteristics of voltage drops across the diodes (X2, X1) are equal to each other.

## Patentansprüche

1. Temperaturstabilisierter HF-Detektor zum Detektieren eines HF-Signals, das an einen HF-Eingangsanschluß (12) angelegt wird, und zum Erzielen einer detektierten Spannung von einem Ausgangsanschluß (13), mit einer Wellenformdetektordiode (X2) mit einer Elektrode, die mit dem Eingangsanschluß (12) verbunden ist, und einer weiteren Elektrode, die mit dem Ausgangsanschluß (13) verbunden ist, einer Temperaturdetektionsdiode (X1), einem Stromversorgungsanschluß (11) und einem Operationsverstärker (A2), der zwischen eine Elektrode der Diode (X1) und eine Elektrode der Wellenformdetektordiode (X2) geschaltet ist, wobei der stromversorgungsanschluß (11) mit einer Elektrode der Temperaturdetektionsdiode (X1) verbunden ist, dadurch gekennzeichnet, daß der Stromversorgungsanschluß (11) mit der einen Elektrode der Temperaturdetektionsdiode (X1) über einen Widerstand (R3) verbunden ist und daß die andere Elektrode der Temperaturdetektionsdiode (X1) mit einer Konstantspanungsquelle (14) verbunden ist, die vom Stromversorgungsanschluß (11) versorgt wird, wobei die Quelle (14) eine vorbestimmte Spannung mit einer niedrigen Ausgangsimpedanz liefert, der Operationsverstärker (A2) einen Teil einer Pufferschaltung (15) bildet, die eine Ausgangsspannung liefert, die im wesentlichen den gleichen Wert hat wie die Spannung an der einen Elektrode der Temperaturdetektionsdiode (X1), die Ausgangsspannung der Pufferschaltung (15) mit einer niedrigen Ausgangsimpedanz geliefert wird und die eine Elektrode der Wellenformdetektordiode (X2), die mit dem Ausgang der Pufferschaltung (15) verbunden ist, die gleiche Polarität hat wie die eine Elektrode der Temperaturdetektionsdiode (X1), die mit dem Eingang der Pufferschaltung (15) verbunden ist.

2. Temperaturstabilisierter HF-Detektor nach Anspruch 1, dadurch gekennzeichnet, daß ein Tiefpaßfilter vorhanden ist, zwischen dem Eingangsanschluß (12) und der Pufferschaltung (15), zum Verhindern, daß das HF-Signal vom Eingangsanschluß (12) zur Pufferschaltung (15) gelangt.

3. Temperaturstabilisierter HF-Detektor nach Anspruch 1 oder 2, dadurch gekennzeichnet, daß der Widerstand des Widerstands (R3) so bemessen ist, daß, wenn eine HF-Signal-Spannung, die vom Eingangsanschluß (12) eingegeben wird, klein ist, die Werte des Stroms, der durch den Wellenformdetektor- und die Temperaturdetektionsdioden (X2, X1) fließt, einander gleich sind, und daß, wenn die Werte des Stroms, der durch den Wellenformdetektor- und durch die Temperaturdetektionsdioden fließt, einander gleich sind, die Temperaturcharakteristik der Spannungsabfälle über den Dioden (X2, X1) einander gleich sind.

## Revendications

1. Détecteur RF stabilisé en température pour détecter un signal RF appliqué à une borne d'entrée RF (12), et obtenir une tension détectée à une borne de sortie (13), comprenant une diode (X2) de détecteur de forme d'onde ayant une électrode connectée à la borne d'entrée (12) et une autre électrode reliée à la borne de sortie (13), une diode de détection de température (X1), une borne d'alimentation (11), et un amplificateur opérationnel (A2) monté entre une électrode de la diode (X1) et la première électrode de la diode (X2) du détecteur de forme d'onde, la borne d'alimentation (11) étant reliée à la première électrode de la diode de détection de température (X1),
caractérisé en ce que la borne d'alimentation (11) est connectée à la première électrode de la diode de détection de température (X1) via une résistance (R3) et en ce que l'autre électrode de la diode de détection de température (X1) est reliée à une source de tension constante (14) alimentée à partir de la borne d'alimentation (11), la source (14) fournissant une tension prédéterminée à une faible impédance de sortie, l'amplificateur opérationnel (A2) constituant une partie d'un circuit tampon (15) qui fournit une tension de sortie de valeur sensiblement égale à la tension à la première électrode de la diode de détection de température (X1), la tension de sortie du circuit tampon (15) étant fournie à une impédance de sortie plus faible, et la première électrode de la diode (X2) du détecteur de forme d'onde qui est connectée à la sortie du circuit tampon (15) ayant la même polarité que la première électrode de la diode de détection de température (X1) qui est connectée à l'entrée du circuit tampon (15).

2. Détecteur RF stabilisé en température selon la revendication 1, caractérisé en ce qu'on fournit un filtre passe-bas entre la borne d'entrée (12) et le circuit tampon (15), afin d'éviter que le signal RF ne circule entre la borne d'entrée (12) et le circuit tampon (15).

3. Détecteur RF stabilisé en température selon la revendication 1 ou la revendication 2, caractérisé en ce que la valeur de la résistance (R3) est telle que, lorsqu'une entrée en tension d'un signal RF à partir de la borne d'entrée (12) est faible, les valeurs des courants traversant les diodes du détecteur de forme d'onde et de détection de température (X2, X1) sont identiques, et en ce que, lorsque les valeurs du courant traversant les diodes du détecteur de forme d'onde et de détection de température sont identiques, les caractéristiques des chutes de la tension en fonction de la température dans les diodes (X2, X1) sont identiques.
